# EUROPEAN PATENT APPLICATION

(11) **EP 2 565 929 A2**
(43) Date of publication of application: **06.03.2013**
(21) Application number: 12179171.9
(22) Date of filing: 03.08.2012
(51) Int. Cl.: H01L 29/51, H01L 29/78, H01L 21/8234, H01L 29/66

(54) **Semiconductor device and method for manufacturing the same**

(30) Priority: 30.08.2011 JP 2011187225
(71) Applicant: Elpida Memory, Inc., Tokyo 104-0028 (JP)
(72) Inventor: Saino, Kanta, Chuo-ku, Tokyo 104-0028 (JP)
(74) Representative: Glawe, Delfs, Moll

(57) **Abstract**

A semiconductor device comprises an MIS field effect transistor including a channel region made of p-conductive silicon, a gate insulating film including a first insulating film having dielectric constant higher than dielectric constant of silicon dioxide, and a gate electrode. The gate electrode includes a first metal film formed on the gate insulating film and having a work function greater than a work function of intrinsic semiconductor silicon, and a p-conductive silicon film formed on the first metal film and in contact with the first metal film.

## Description

### BACKGROUND OF THE INVENTION

### Field of the Invention

The present invention relates to a semiconductor device and a method for manufacturing the same.

### Description of the Related Art

A gate insulating film used in a transistor has been made of silicon dioxide having a dielectric constant of about 3.9. As a transistor is miniaturized and the thickness of the gate insulating film decreases accordingly, the amount of leak current increases and hence the transistor device disadvantageously consumes large power and requires large standby power. In view of the situation described above, there has developed a transistor which comprises an insulating film having a dielectric constant higher than that of a silicon oxide film (high dielectric constant insulating film) is used as the gate insulting film (hereinafter referred to as a "high dielectric constant gate insulting film" in some cases). In this transistor, the actual thickness of the insulating film is thicker than that of a silicon oxide film, but an effective oxide thickness (EOT) of the insulating film can be thinned.

However, simply combining a polycrystalline silicon gate electrode in related art and a high dielectric constant gate insulting film disadvantageously leads to a phenomenon called gate electrode depletion, in which depletion layer capacitance is formed between the high dielectric constant gate insulting film and the polycrystalline silicon gate electrode and disables the advantage of the high dielectric constant gate insulting film, which is a thin EOT. To prevent the gate electrode depletion, the portion of the gate electrode that is in contact with the high dielectric constant gate insulting film is made of a metal layer instead of the polycrystalline silicon layer.

On the other hand, when the gate electrode is made only of a metal layer, the following problems occur: (1) Since gate electrode-based threshold voltage control depends on film thickness, it is difficult to achieve a thickness that satisfies a desired threshold voltage and resistance using only a metal layer, and (2) It is difficult to form the gate electrode entirely with a metal layer in terms of manufacturability. To solve the problems described above, a transistor including a gate electrode formed by stacking a polycrystalline silicon layer on a metal layer has been proposed.

JP2011-14689 discloses an HKMG transistor in which TiN and polycrystalline silicon as a gate electrode are stacked on a high dielectric constant gate insulting film. In the process for forming the transistor, polycrystalline silicon electrodes 112 and 118 are positioned as top layers of gate electrodes, and ion implantation is performed using polycrystalline silicon electrodes 112 and 118 as a mask, in order to form extension layers 108 and 114 and diffusion layers 107 and 113 to be source and drain regions. An impurity of the same conductivity type as that of the channel is doped into the polycrystalline silicon electrode in each transistor. In other words, an n-type impurity is doped into the polycrystalline silicon electrode 118 in an n-channel transistor, whereas a p-type impurity is doped into the polycrystalline silicon electrode 112 in a p-channel transistor.

In the process of forming a transistor including a gate electrode made of polycrystalline silicon, the impurity is introduced into the polycrystalline silicon gate electrode by impurity implantation for forming an extension layer, a source region, and a drain region in some cases. The thus formed polycrystalline silicon gate electrode has a structure containing the impurity which has the same polarity as the conductivity type of the channel of the transistor.

JP2009-267180 discloses an HKMG transistor obtained by stacking a metal film (made, for example, of TiAIN or TiN) and polycrystalline silicon as a gate electrode on a high dielectric constant gate insulting film. In a method for manufacturing the transistor, conductive film 32 made of n-conductive polycrystalline silicon to which phosphorus as the impurity is doped, is deposited on gate insulating film 5 and first metal film 30 or a stacked film of first metal film 30 and second metal film 31. Gate electrodes 6 and 7 are then formed by processing the stacked film. In both of p-type transistor Qp and n-type transistor Qn, conductive film 32 constituting gate electrodes 6 and 7 is made of n-conductive polycrystalline silicon.

As described above, in the process of forming a transistor including a gate electrode made of polycrystalline silicon, an impurity is doped into a polycrystalline silicon in advance at the time of depositing the polycrystalline silicon in some cases. In particular, it is known that n-conductive polycrystalline silicon is lower than p-conductive polycrystalline silicon in terms of resistivity of polycrystalline silicon itself. An impurity to be doped in advance into polycrystalline silicon is therefore typically a donor impurity, as described in JP2009-267180. The thus formed polycrystalline silicon gate electrode is n-conductive irrespective of the conductivity type of the channel of the transistor and has a structure containing a donor impurity.

The inventor has investigated the KKMG gate stack structure as disclosed in JP2011-14689, in which the metal gate electrode and polycrystalline silicon are stacked. As a result, the inventor has found that n-channel transistor has an interface resistance between the metal gate electrode and polycrystalline silicon in the gate electrode higher than that of p-channel transistor.

### SUMMARY

In one embodiment, there is provided a semiconductor device comprising an MIS field effect transistor,
the MIS field effect transistor comprising:
a channel region made of p-conductive silicon;
a gate insulating film including a first insulating film that is higher in dielectric constant than silicon dioxide; and
a gate electrode formed on the gate insulating film, the gate electrode including a first metal film and a p-conductive silicon film, the first metal film being greater in work function than intrinsic semiconductor silicon, the first metal film and the p-conductive silicon film being in contact with each other.

In another embodiment, there is provided a method for manufacturing a semiconductor device, comprising:
implanting a donor impurity into part of a semiconductor substrate to form a first semiconductor region having n-conductive type;
implanting an acceptor impurity into other part of the semiconductor substrate to form a second semiconductor region having p-conductive type;
forming a first insulating film on the semiconductor substrate to cover the first and second semiconductor regions, the first insulating film being higher in dielectric constant than silicon dioxide;
forming a conductive film on the first insulating film, the conductive film comprising a first metal film and a p-conductive silicon film, the first metal film and the p-conductive silicon film being in contact with each other, the first metal film being greater in work function than intrinsic semiconductor silicon; and,
partially removing the conductive film and the first insulating film to form gate structures on each surfaces of the first and second semiconductor regions.

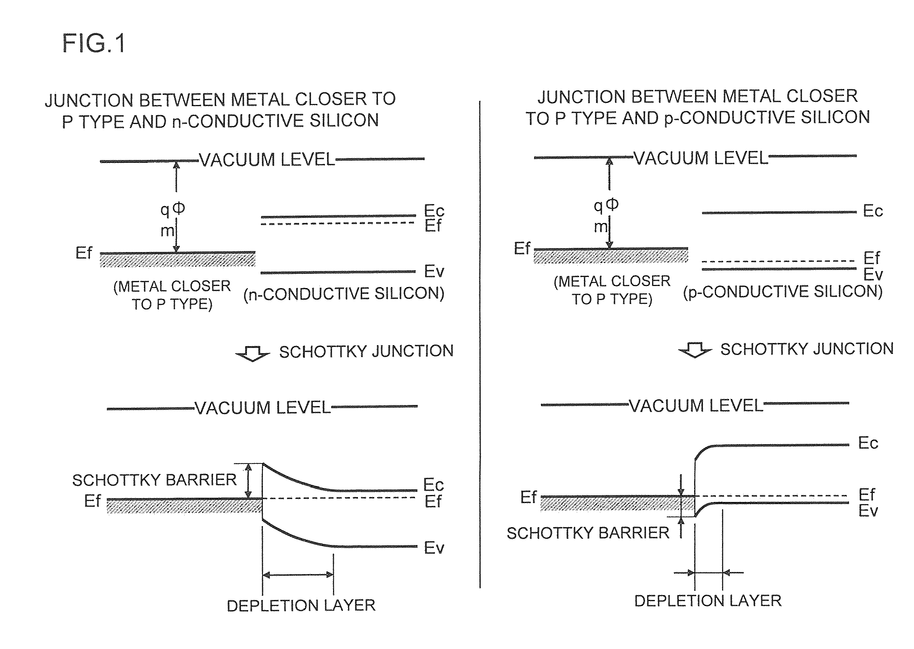

FIG. 1 describes operation and effects of the semiconductor device. Generally, when the conductive silicon film is formed on the first metal film as the gate electrode, Schottky junction is produced. In the Schottky junction, band discontinuity between the metal-side Fermi level (Ef) and the silicon-side majority carrier band end (Ec or Ev) appears as an energy barrier (Schottky barrier) for the majority carrier, resulting in producing interface resistance. Further, the higher the Schottky barrier, the greater the width of the depletion layer that spreads from the interface toward the silicon, resulting in an increase in resistance of the silicon having a finite thickness.

For example, when a high dielectric constant gate insulating film, such as hafnium oxide, zirconium oxide, hafnium silicate, and zirconium silicate which has a dielectric constant higher than that of silicon dioxide, is used, the metal material used as the first metal film, such as titanium nitride, tantalum nitride, hafnium nitride, and titanium carbide, has a relatively large work function Φm, and the work function Φm is larger than that of intrinsic semiconductor silicon. In other words, Fermi level Ef of the metal material used as the first metal film is closer to valence band end Ev than to conduction band end Ec of silicon (The first metal film made of such a metal material is hereinafter referred to as a "first metal film closer to p type"). When n-conductive silicon is joined with such a first metal film closer to p type, the energy barrier from metal Fermi level closer to p type Ef to conductive band end Ec is high and the depletion layer spreads widely into the n-type silicon. In this case, the interface resistance increases.

In contrast, when p-conductive silicon is joined with a first metal film closer to p type, the energy barrier from metal Fermi level closser to p type Ef to valence band end Ev lowers and the size of the depletion layer that spreads into the p-type silicon decreases. Accordingly, the interface resistance decreases.

For example, the n-channel and p-channel transistors constituting CMOS are required to have characteristics highly symmetric with each other. To this end, it is usual to configure the gate electrode of the n-channel transistor to be n-conductive and the gate electrode of the p-channel transistor to be p-conductive, as described in JP2011-14689. Since in terms of the resistivity of silicon itself, n-conductive silicon is lower than p-conductive silicon, it is usual that the skilled in the art who desire to lower the resistance of silicon itself dopes a donor impurity into silicon to make it n-conductive, as described in JP2009-267180.

In contrast, the present inventor focused attention to the fact that in a stacked structure of metal material/silicon used as the gate electrode of a field effect transistor using a high dielectric constant gate insulating film, the phenomenon described above occurs in the vicinity of the interface due to Schottky junction of the interface between the metal material and the polycrystalline silicon, and the phenomenon prevents the resistance from being lowered. In one exemplary embodiment of the present invention, a silicon film (polycrystalline silicon film, for example) in contact with a first metal film closer to p type in a gate electrode is made p-conductive. As a result, the interface resistance between the first metal film closer to p type and the silicon film can be lowered.

### BRIEF DESCRIPTION OF THE DRAWING

The above features and advantages of the present invention will be more apparent from the following description of certain preferred embodiments taken in conjunction with the accompanying drawings, in which:
FIG, 1 describes operation and effects of a semiconductor device according to the present invention;
FIG. 2 shows a method for manufacturing a semiconductor device according to a first exemplary embodiment;
FIG. 3 shows the method for manufacturing the semiconductor device according to the first exemplary embodiment;
FIG. 4 shows the semiconductor device according to the first exemplary embodiment;
FIG. 5 shows a method for manufacturing a semiconductor device according to a second exemplary embodiment;
FIG. 6 shows the method for manufacturing the semiconductor device according to the second exemplary embodiment;
FIG. 7 shows the method for manufacturing the semiconductor device according to the second exemplary embodiment;
FIG. 8 shows the method for manufacturing the semiconductor device according to the second exemplary embodiment;
FIG. 9 shows the method for manufacturing the semiconductor device according to the second exemplary embodiment;
FIG. 10 shows the method for manufacturing the semiconductor device according to the second exemplary embodiment;
FIG. 11 shows the method for manufacturing the semiconductor device according to the second exemplary embodiment;
FIG. 12 shows the method for manufacturing the semiconductor device according to the second exemplary embodiment;
FIG. 13 shows the method for manufacturing the semiconductor device according to the second exemplary embodiment;
FIG. 14 shows the method for manufacturing the semiconductor device according to the second exemplary embodiment;
FIG. 15 shows the method for manufacturing the semiconductor device according to the second exemplary embodiment; and
FIG. 16 shows a semiconductor device according to the second exemplary embodiment.

In the drawings, numerals have the following meanings: 1: semiconductor substrate, 2: n-well, 3: p-well, 4: isolation region, 5, 5a, 5b: silicon oxide film or silicon nitride film, 6, 6a, 6b: high dielectric constant insulating film (high-k film), 7: first metal film, 7a, 7b: first metal film, 8: amorphous silicon film, 8a: p-conductive first polycrystalline silicon film, 8b: p-conductive second polycrystalline silicon film, 9, 9a, 9b: barrier metal film, 10: fourth metal film, 10a, 10b: gate wiring, 11: silicon nitride film, 11a, 11b: cap insulating film, 12: offset spacer, 13: sidewall spacer, 14: interlayer insulating film, 15: contact plug, 16: upper layer wiring, 21: gate electrode, 22: gate insulating film, 23: source and drain regions, 24: bit contact interlayer insulating film, 25: silicon oxide film, 26: high dielectric constant insulating film, 27: first metal film, 28a: first mask, 28b: second mask, 28c: third mask, 28d: fourth mask, 28e: fifth mask, 29: contact hole, 30: polycrystalline silicon film, 30a: p-conductive polycrystalline silicon film, 30b: n-conductive polycrystalline silicon film, 31: cap insulating film, 32: fourth metal film, 33: second metal film, 34: bit line, 35: offset spacer insulating film, 36: offset spacer, 37a, 37b: LDD region, 38: silicon oxide film, 39: offset spacer, 40a, 40b: source and drain regions, 41: contact hole, 42: first interlayer insulating film, 43: capacitance contact sidewall, 44: capacitance contact hole, 45: polycrystalline silicon (DOPOS) film, 46: cobalt silicide film, 47: tungsten film, 48: capacitance contact pad, 49: second interlayer insulating film, 50: third interlayer insulating film, 51a, 51b: LDD region, 52a, 52b: source and drain regions, 53: lower electrode, 55: upper electrode, 58: capacitance insulating film, 60: capacitance contact plug, 62: wiring, A: memory cell formation region, B: peripheral circuit formation region, Cap: capacitor, Tr1: n-channel transistor, Tr2: p-channel transistor, Tr3: memory-cell transistor, X: memory cell region, Y: peripheral circuit region

### DETAILED DESCRIPTION OF THE PREFERRED EMBODIMENTS

One exemplary embodiment of a semiconductor device includes a MIS field effect transistor. The MIS field effect transistor includes a gate electrode formed on a gate insulating film including a first insulating film. The gate electrode includes a first metal film formed on the gate insulating film and having a work function greater than that of intrinsic semiconductor silicon, and a p-conductive silicon film formed on the first metal film and in contact with the first metal film.

The invention will be now described herein with reference to illustrative embodiments. Those skilled in the art will recognize that many alternative embodiments can be accomplished using the teachings of the present invention and that the invention is not limited to the embodiments illustrated for explanatory purposes.

### (First Exemplary Embodiment)

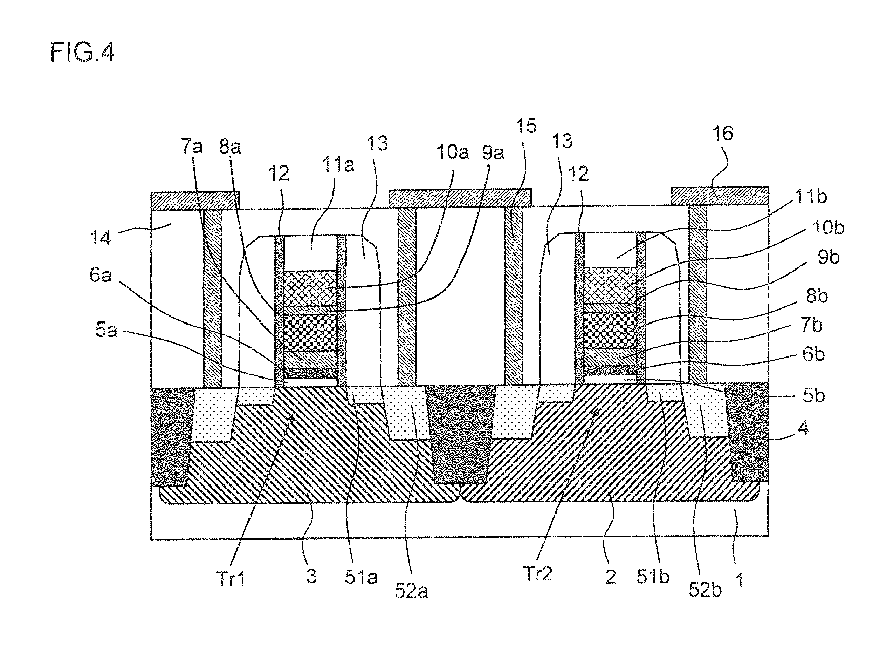

A first exemplary embodiment relates to a semiconductor device including n-channel and p-channel transistors. FIG. 4 is a cross-sectional view showing the semiconductor device according to the first exemplary embodiment, and in the semiconductor device, n-channel transistor Tr1 and p-channel transistor Tr2 are provided.

Transistor Tr1 includes p-well 3 (second semiconductor region) provided in semiconductor substrate 1 made of silicon, LDD region 51a and n-type source and drain regions 52a provided in p-well 3, a first gate insulating film, and a first gate electrode. The first gate insulating film and first gate electrode constitute a gate structure. The first gate insulating film is formed of silicon oxide film or silicon nitride film (corresponding to second insulating film) 5a and high dielectric constant insulating film (high-k film) (corresponding to first insulating film containing first insulating material) 6a having a dielectric constant higher than that of silicon dioxide, and the components described above are formed in this order from the side of semiconductor substrate 1. Silicon oxide film or silicon nitride film 5a can stabilize the interface characteristic of semiconductor substrate 1. Since high dielectric constant insulating film 6a has a high dielectric constant, it can improve EOT (equivalent oxide thickness).

The first gate electrode of transistor Tr1 is formed of first metal film 7a having a work function greater than that of intrinsic semiconductor silicon, p-conductive polycrystalline silicon film 8a, barrier metal film 9a made of a second metal material (second metal film), and a conductive film made of gate wiring 10a in this order from the side of the first gate insulating film. Using first metal film 7a allows a desired work function to be set, in order to adjust the threshold voltage. Further, first metal 7a cannot be formed to a desired thickness because the threshold voltage varies and it is difficult to process first metal film 7a. The gate electrode can be formed to a desired thickness by using polycrystalline silicon film 8a, which is readily processed. Using barrier metal film (second metal film) 9a prevents polycrystalline silicon film 8a from reacting with gate wiring 10a so that the metal that forms gate wiring 10a is silicified. Gate wiring 10a allows the gate electrodes of a plurality of transistors to be electrically connected to each other.

Cap insulating film 11a made of a silicon nitride film is provided on gate wiring 10a in transistor Tr1. Cap insulating film 11a can be used in later steps not only as a hard mask when the first metal film 7a, the polycrystalline silicon film 8a, the second metal film 9a, and the metal film for the gate wiring 10a are etched to change these film into a shape of the gate electrode but also as a mask when an impurity is implanted in order to form the LDD region 51a and the source and drain regions 52a. Offset spacers 12 made of a silicon nitride film are provided on each side of the gate electrode. Sidewall spacers 13 made of a silicon oxide film are further provided on each offset spacer 12.

Transistor Tr2 includes n-well 2 (first semiconductor region) provided in semiconductor substrate 1, LDD region 51b and p-conductive source and drain regions 52b provided in n-well 2, a second gate insulating film including a high dielectric constant insulating film, and a second gate electrode. The second gate insulating film and second gate electrode constitute a gate structure. The second gate insulating film is formed of silicon oxide film or silicon nitride film (second insulating film) 5b and high dielectric constant insulating film (high-k film) (first insulating film) 6b having a dielectric constant higher than that of silicon dioxide, in this order from the side of semiconductor substrate 1. The second gate electrode is formed of first metal film 7b" p-conductive polycrystalline silicon film 8b, barrier metal film (second metal film) 9b, and gate wiring 10b, in this order from the side of the second gate insulating film. Cap insulating film 11b, offset spacers 12, and sidewall spacers 13 are also provided in transistor Tr2, as in transistor Tr1.

Interlayer insulating film 14 is provided over semiconductor substrate 1 to cover transistors Tr1 and Tr2. Upper layer wiring 16 is provided on interlayer insulating film 14 and electrically connected to source and drain regions 52a, 52b via contact plugs 15 provided so as to penetrate through interlayer insulating film 14. P-well 3 and n-well 2 are electrically isolated with each other by isolation region 4.

In operation of transistor Tr1, a channel region is formed in a region directly below the first gate electrode in p-well 3. Similarly, in operation of transistor Tr2, a channel region is formed in a region directly below the second gate electrode in n-well 2.

In the first exemplary embodiment, the first and second gate electrodes include p-conductive polycrystalline silicon films 8a and 8b on first metal films 7a and 7b, respectively. Further, the first and second gate insulating films have high dielectric constant insulating films 6a and 6b in contact with metal films 7a and 7b, respectively. When the p-conductive polycrystalline silicon films 8a and 8b are thus joined with first metal films closer to p type 7a and 7b, the energy barrier from metal Fermi level closer to p type Ef to valence band end Ev lowers. As a result, the size of the depletion layer that spreads into each of the p-type polycrystalline silicon films 8a and 8b decreases, thereby reducing the resistance. Further, as the barrier metal films (second metal films) 9a and 9b which prevent the polycrystalline silicon films from being chemically combined with tungsten wiring, titanium nitride or tantalum nitride are formed on the polycrystalline silicon films 8a and 8b. These barrier metal films 9a and 9b also have Fermi levels in the vicinity of the valence band end of silicon and are closer to p type, as first metal films 7a and 7b. Therefore, in the first exemplary embodiment, conversion of polycrystalline silicon into p-conductive polycrystalline silicon lowers interface resistance resulting from not only Schottky junction between the polycrystalline silicon and first metal films 7a, 7b but also Schottky junction between the polycrystalline silicon 8a and 8b and the barrier metal films 9a and 9b.

The high dielectric constant insulating film (first insulating film) 6a and 6b of each of transistors Tr1 and Tr2 may be a monolayer film or a stacked film of a plurality of films and preferably has a dielectric constant higher than that of silicon nitride. The high dielectric constant insulating film can be made, for example, of at least one insulating material (first insulating material) selected from the group consisting of HfSiON, ZrO₂, Ta₂O₅, Nb₂O₅, Al₂O₃, HfO₂, Sc₂O₃, Y₂O₃, La₂O₃, CeO₂, Pr₂O₃, Nd₂O₃, Sm₂O₃, Eu₂O₃, Gd₂O₃, Tb₂O₃, Dy₂O₃, HO₂O₃, Er₂O₃, Tm₂O₃, Yb₂O₃, Lu₂O₃, HfSiO, ZrSiO and ZrSiON.

Each of first metal films 7a and 7b may be a monolayer film or a stacked film of a plurality of films and may be made of at least one film selected from the group consisting of titanium nitride, tantalum nitride, hafnium nitride, and titanium carbide.

It is preferable that the barrier metal film (second metal film) 9a and 9b has the work function greater than the work function of intrinsic semiconductor silicon, The barrier metal film 9a and 9b of each of transistors Tr1 and Tr2 may be made of at least one film selected from the group consisting of titanium nitride, tantalum nitride, hafnium nitride, and titanium carbide, and tungsten nitride. The gate wiring 10a and 10b can be made of a tungsten film.

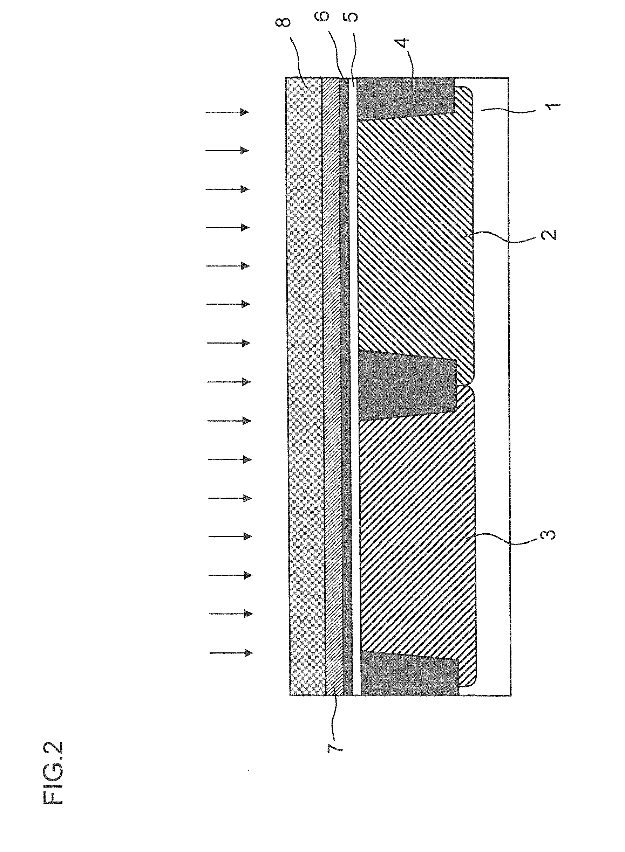

A method for manufacturing the semiconductor device according to the first exemplary embodiment will be described below with reference to FIGS. 2 to 10. As shown in FIG. 2, Isolation regions 4 are formed in silicon semiconductor substrate 1 in an STI process. A donor impurity is implanted into a part of the silicon semiconductor substrate 1 to form n-well 2 (first semiconductor region having n-conductive type). An acceptor impurity is implanted into the other part of the silicon semiconductor substrate 1 to form p-well 3 (second semiconductor region having p-conductive type). The surface of semiconductor substrate 1 is thermally oxidized to form silicon oxide film 5. The thickness of silicon oxide film 5 is set, for example, at 1 nm. A silicon oxynitride film may be used in place of the silicon oxide film. High dielectric constant insulating film 6 is then formed on silicon oxide film 5. The thickness of high dielectric constant insulating film 6 is set, for example, at 3 nm. First metal film 7 is formed on high dielectric constant insulating film 6. The thickness of first metal film 7 is set, for example, at 10 nm. First metal film 7 may alternatively be a stacked film of a plurality of metal layers. Amorphous silicon film 8 is then formed on first metal film 7. The thickness of amorphous silicon film 8 is set, for example, at 100 nm. A p-conductive impurity to be implanted into the silicon film in a later step tends to be localized at grain boundaries in the silicon. In view of the fact, amorphous silicon film 8 having small grain sizes is formed in one of the steps shown in FIG. 2, thereby facilitating distributing the p-conductive impurity uniformly in the later step. The p-conductive impurity is then implanted into amorphous silicon film 8. According to the method described above, since the dose of the impurity and the amount of implanting energy to be readily adjusted, the impurity having high concentration can be doped into amorphous silicon film 8. B is used as the impurity element, and the dose thereof is set at 5×10¹⁵/cm² at 5 keV. For example, the p-conductive impurity can be at least one element selected from the group consisting of B (boron), In (indium), and Ga (garium). The dose of the impurity can range from 1×10¹⁵ to 1×10¹⁶/cm². When the dose is greater than or equal to 1×10¹⁵/cm², the resistance of the silicon film having a desired low value can be formed. When the dose is smaller than or equal to 1×10¹⁶/cm², it is possible to prevent the p-conductive impurity from diffusing abnormally. The energy used to implant the impurity is so selected that the metal film or the high dielectric constant insulating film is not contaminated with the impurity. The amorphous silicon film is then converted into a polycrystalline silicon film by heat treatment to form p-conductive polycrystalline silicon film 8. In the heat treatment, annealing can also be performed to activate the implanted impurity. As a result of the implantation of the impurity in the implantation conditions described above and the activation of the impurity, the concentration of the p-conductive impurity in polycrystalline silicon film 8 ranges from 1×10²⁰ to 1×10²¹/cm³. Alternatively, a polycrystalline silicon film may be deposited in advance in the silicon film formation process, and the heat treatment for forming polycrystalline silicon in the later step may be omitted.

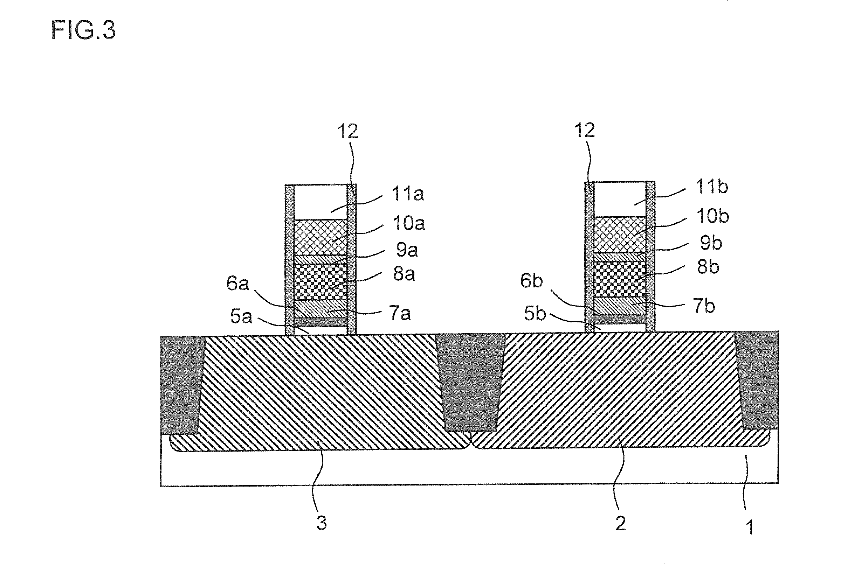

As shown in FIG. 3A, second metal film, such as a titanium nitride film or a tantalum nitride film, is formed on p-conductive polycrystalline silicon film 8. The thickness of the second metal film is set, for example, at 10 nm. A third metal film, such as a tungsten film, is then formed on the second metal film. The thickness of the third metal film is set, for example, at 80 nm. A silicon nitride film is further formed on the third metal film. The thickness of the silicon nitride film is set, for example, at 150 nm. The silicon nitride film is patterned by using a lithography technique to form cap insulating films 11a and 11b, which function as a hard mask. The hard mask is used to pattern the stack film of silicon oxide film 5, high dielectric constant insulating film 6, first metal film 7, p-conductive polycrystalline silicon film 8, the second metal film, and the third metal film. Thus, there are formed the first gate insulating film made of silicon oxide film 5a and high dielectric constant insulating film 6a, and the first gate electrode formed of first metal film 7a, p-conductive polycrystalline silicon film 8a, barrier metal film 9a, and gate wiring 10a on p-well 3. At the same time, there are formed the second gate insulating film made of silicon oxide film 5b and high dielectric constant insulating film 6b, and the second gate electrode formed of first metal film 7b, p-conductive polycrystalline silicon film 8b, barrier metal film 9b, and gate wiring 10b on n-well 2. Offset spacers 12 are then formed on the sidewalls of the first and second gate insulating films and the first and second gate electrodes by forming a silicon nitride film over semiconductor substrate 1 and then etching back the silicon nitride film. Offset spacers 12 also have a function of preventing an oxidant and a reductant resulting from increase of the EOT, from diffusing high dielectric constant insulating films 6a and 6b.

As shown in FIG. 4, LDD region 51a is formed by implanting an n-conductive impurity (donor impurity) into p-well 3 using the gate structure on p-well 3 as an implantation mask. LDD region 51b is then formed by implanting a p-conductive impurity (acceptor impurity) into n-well 2 using the gate structure on n-well 2 as an implantation mask. Sidewall spacers 13 are then formed on the sidewalls of the first and second gate electrodes via offset spacers 12 by further forming a silicon oxide film over semiconductor substrate 1 and then etching back the silicon oxide film. Source and drain regions 52a are then formed by implanting an n-conductive impurity (donor impurity) into p-well 3 using the gate structure on p-well 3 as an implantation mask. Source and drain regions 52b are then formed by implanting a p-conductive impurity (acceptor impurity) into n-well 2 using the gate structure on n-well 2 as an implantation mask. N-channel transistor Tr1 and p-channel transistor Tr2 are thus completed. Interlayer insulating film 14 is then formed over semiconductor substrate 1. Contact holes are formed in interlayer insulating film 14 so that source and drain regions 52a, 52b of transistors Tr1 and Tr2 are exposed. The contact holes are filled with a conductive material. Contact plugs 15 are then formed by planarizing the conductive material, for example, by a CMP process. Upper layer wirings 16 electrically connected to contact plugs 15 are formed on interlayer insulating film 14.

In the first exemplary embodiment, after amorphous silicon film 8 is deposited, a p-conductive impurity is ion-implanted into amorphous silicon film 8 to form p-conductive amorphous silicon film 8 in one of the steps shown in FIG. 2. An amorphous silicon film may be deposited using a process gas containing the p-conductive impurity in place of the above process. According to this method, the process of implanting the p-conductive impurity can be omitted. As the other process, after the amorphous silicon film is deposited, the p-conductive impurity may be implanted into the amorphous silicon film by a plasma doping process. According to this method, the process time can be shortened, and the impurity having high concentration can be doped into the vicinity of the surface of the amorphous silicon film.

### (Second Exemplary Embodiment)

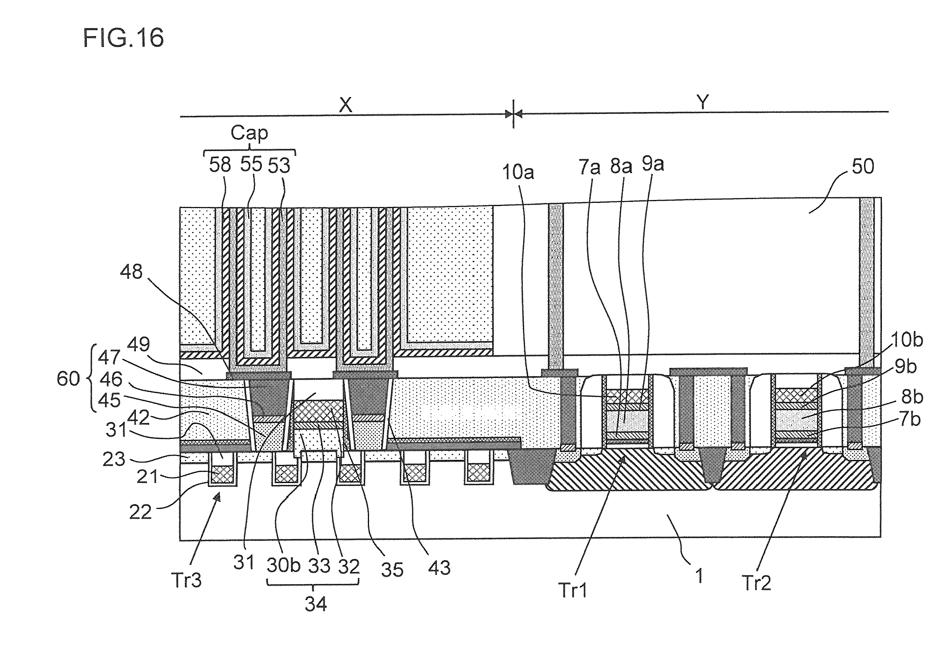

A second exemplary embodiment relates to a case where the structure according to the first exemplary embodiment is used as a peripheral transistor in a DRAM (dynamic random access memory). FIG. 16 is a cross-sectional view showing a semiconductor device according to the second exemplary embodiment. As shown in FIG. 16, the semiconductor device according to the second exemplary embodiment includes memory cell region X and peripheral circuit region Y. The structure of peripheral circuit region Y is the same as the structure described in the first exemplary embodiment, and here, no description thereof will therefore be made.

In memory cell region X, there is provided memory-cell transistor Tr3 which includes trench-shaped gate electrode 21 provided in semiconductor substrate 1, gate insulating film 22, and source and drain regions 23. Cap insulating film 31 is provided on trench-shaped gate electrode 21. On semiconductor substrate 1, there are sequentially provided first interlayer insulating film 42, second interlayer insulating film 49, and third interlayer insulating film 50. Bit line 34 connected to one of source and drain regions 23 is provided in first interlayer insulating film 42. Bit line 34 is formed by stacking n-conductive polycrystalline silicon film 30b, barrier metal film 33, and third metal film 32 in this order from the side of the one of the source and drain regions. Cap insulating film 31 is provided on bit line 34.

Capacitance contact plug 60 connected to the other one of source and drain regions 23 is provided in first interlayer insulating film 42. Capacitance contact plug 60 is formed by stacking polycrystalline silicon film (DOPES) 45 into which an impurity is doped, cobalt silicide film 46, and tungsten film 47 in this order from the side of the other one of the source and drain regions. Offset spacer insulating film 35 and capacitance contact sidewall 43 electrically isolate bit line 34 and capacitance contact plug 60 from each other. Capacitance contact pad 48 connected to the capacitance contact plug 60 is provided in second interlayer insulating film 49. Capacitor Cap formed of lower electrode 53, capacitance insulating film 58, and upper electrode 55 is provided so that capacitor Cap is connected to capacitance contact pad 48.

Capacitor Cap and transistor Tr3 form a memory cell, and a plurality of memory cells form the DRAM.

In the second exemplary embodiment, in each of the first and second gate electrodes in peripheral circuit region Y, the contact (interface) resistance at the interface between the polycrystalline silicon film 8a and 8b and the first metal film 7a and 7b can be lowered. Further, a titanium nitride or tantalum nitride as a barrier metal film 9a and 9b is formed on the polycrystalline silicon film 8a and 8b, in order to prevent reaction between the polycrystalline silicon film 8a and 8b and the tungsten wiring 10a and 10b. The resistance resulting from Schottky junction between the polycrystalline silicon film 8a and 8b and the barrier metal film 9a and 9b can therefore be also lowered. As a result, the performance of the entire semiconductor device including the DRAM can be enhanced.

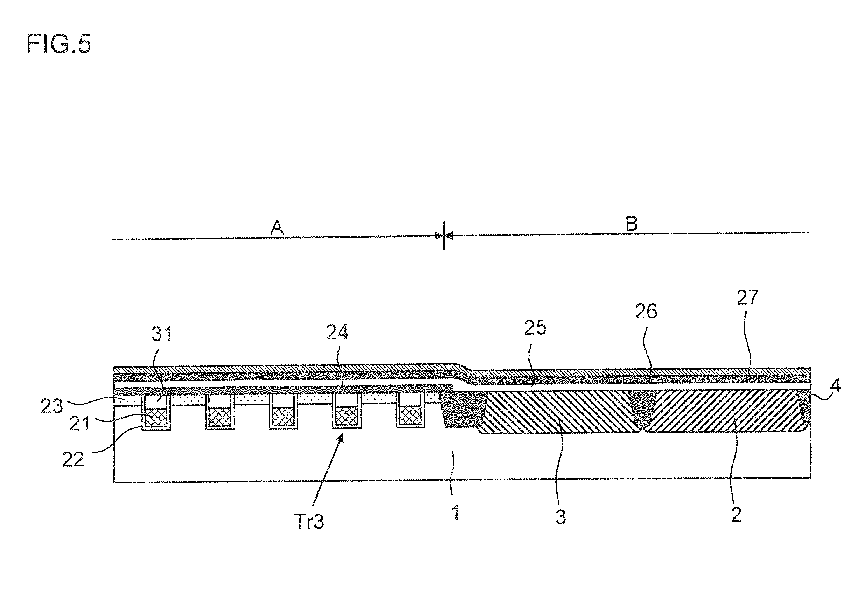

A method for manufacturing the semiconductor device according to the second exemplary embodiment will be described below with reference FIGS. 5 to 16. In the following description, a region where a semi-completed memory cell is formed and a region where a semi-completed peripheral circuit is formed are called "memory cell formation region A" and "peripheral circuit formation region B," respectively, and distinguished from "memory cell region X" and "peripheral circuit region Y," which are completed regions.

As shown in FIG. 5, isolation regions 4 are formed in semiconductor substrate 1, for example, by an STI process. P-well 3 and n-well 2 are then formed in peripheral circuit formation region B, and a p-conductive impurity is implanted into memory cell formation region A. Trenches are formed in the memory cell formation region by using a lithography technique. Gate insulating film 22 made of a silicon oxide film is formed on the inner wall of each of the trenches, for example, by a thermal treatment. Gate electrode 21 and cap insulating film 31 made of a silicon nitride film are then formed so that they are buried in each of the trenches. Source and drain regions 23 are formed by implanting an n-conductive impurity into memory cell formation region A. Memory-cell transistors Tr3 are thus completed. Bit contact interlayer insulating film 24 is formed by forming an insulating film on semiconductor substrate 1, for example, by a CVD process and then removing the insulating film in peripheral circuit formation region B by a lithography process. Silicon oxide film 25, high dielectric constant insulating film 26, and first metal film 27 are then formed over semiconductor substrate 1.

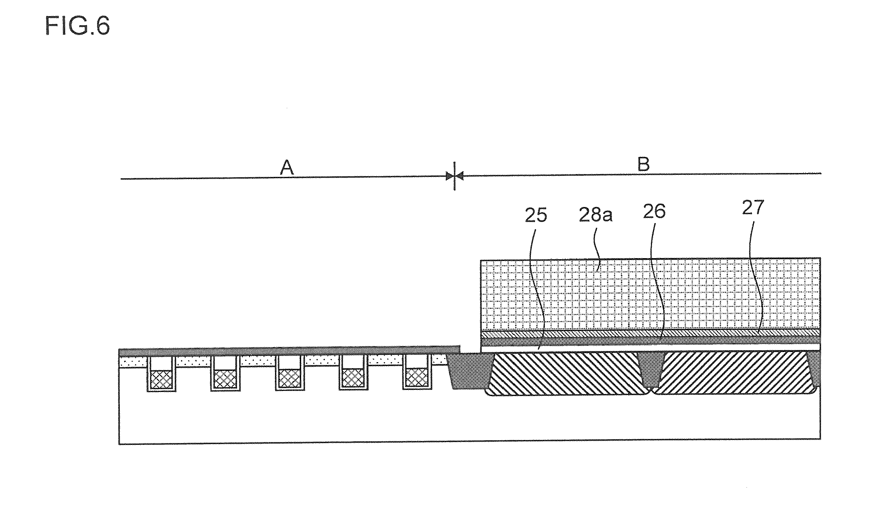

As shown in FIG. 6, first mask 28a is formed over peripheral circuit formation region B, and silicon oxide film 25, high dielectric constant insulating film 26, and first metal film 27 in memory cell formation region A are then removed by an etching process using first mask 28.

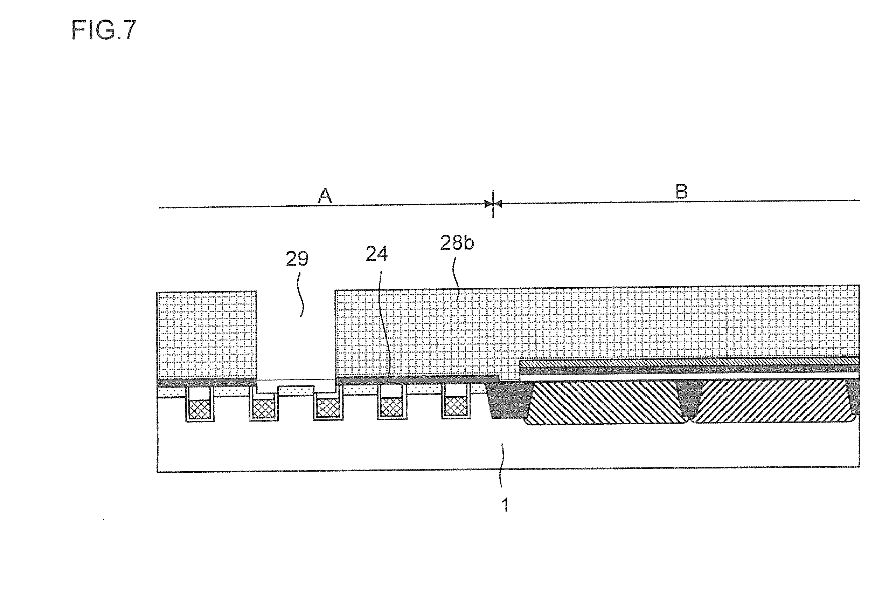

As shown in FIG. 7, after first mask 28a is removed, second mask 28b including opening 29 that exposes bit contact interlayer insulating film 24 in memory cell formation region A is formed over semiconductor substrate 1. Second mask 28b is used to remove exposed bit contact interlayer insulating film 24.

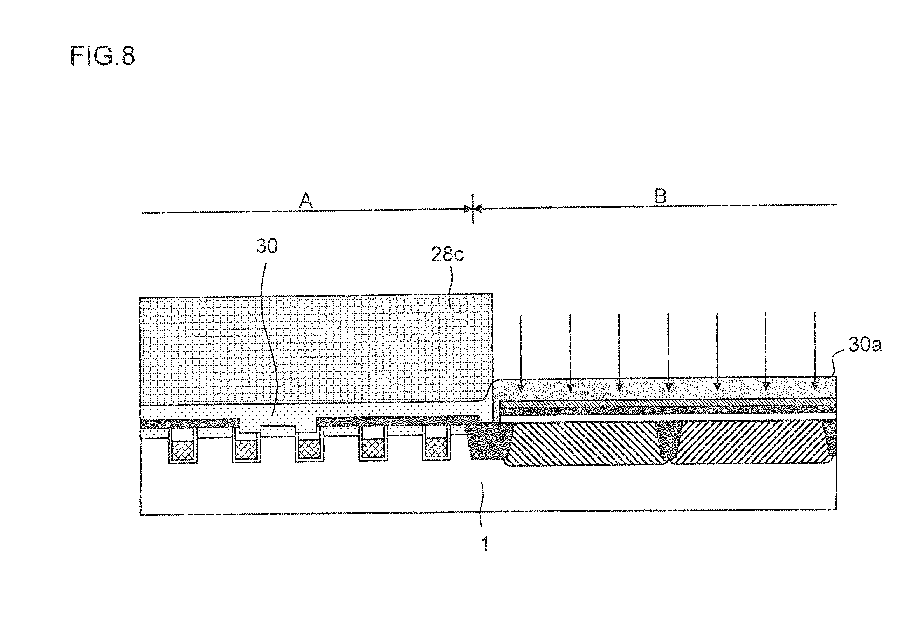

As shown in FIG. 8, after second mask 28b is removed, polycrystalline silicon film 30 is formed over semiconductor substrate 1. Third mask 28c is formed over memory cell formation region A, and a p-conductive impurity is then ion-implanted into polycrystalline silicon film 30 in peripheral circuit formation region B to form p-conductive polycrystalline silicon film 30a.

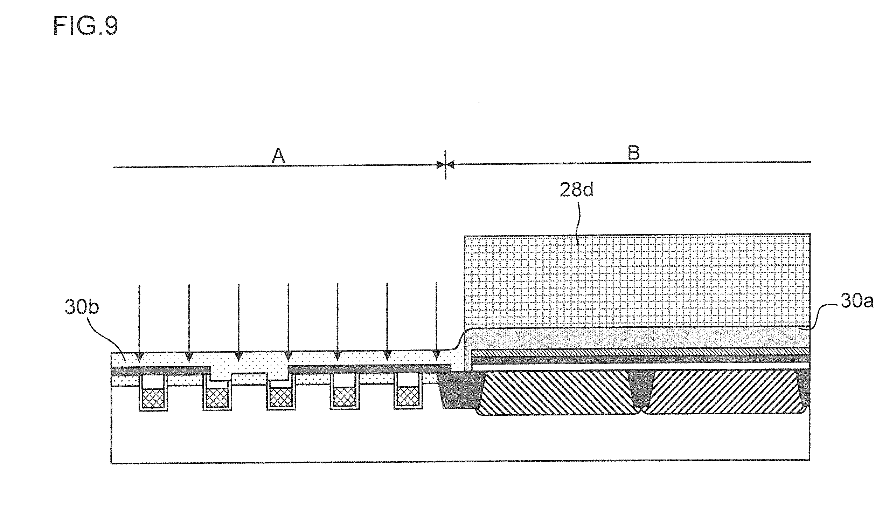

As shown in FIG. 9, after third mask 28c is removed, fourth mask 28d is formed to cover polycrystalline silicon film 30a in peripheral circuit formation region B. N-conductive polycrystalline silicon film 30b is formed by ion-implanting an n-conductive impurity into polycrystalline silicon film 30 in memory cell formation region A.

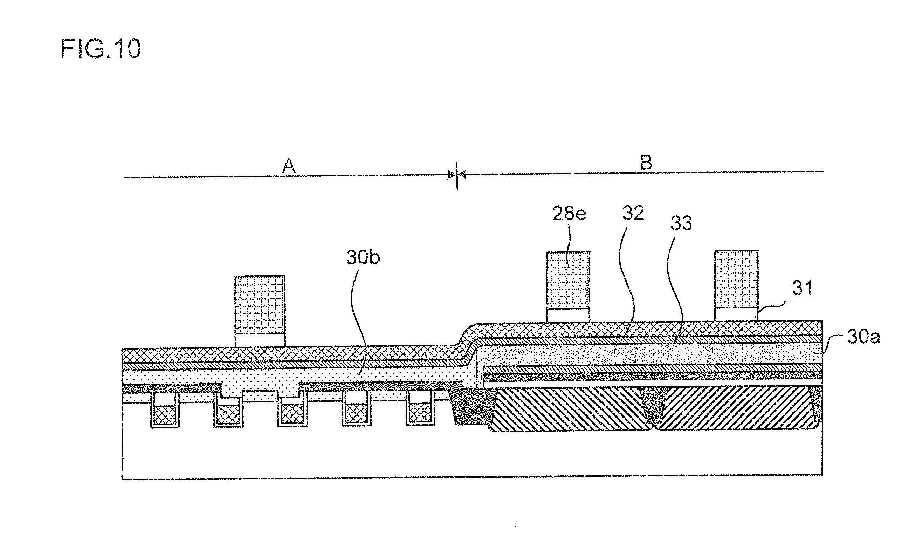

As shown in FIG. 10, second metal film 33 made of tungsten nitride, third metal film 32 made of tungsten, and silicon nitride film 31 are formed in this order on polycrystalline silicon films 30a and 30b. Silicon nitride film 31 is patterned by using fifth mask 28e to form a hard mask made of patterned cap insulating film 31.

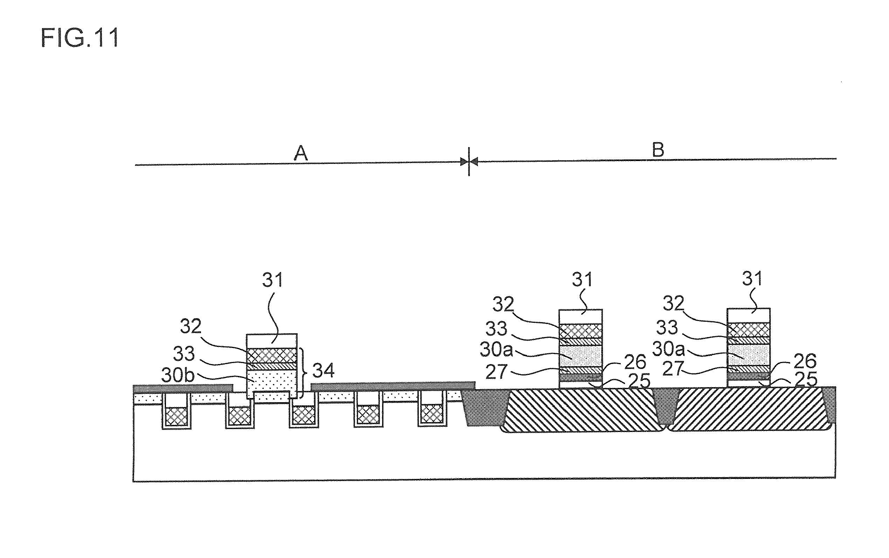

As shown in FIG. 11, after fifth mask 28e is removed, in peripheral circuit formation region B, third metal film 32, second metal film 33, p-conductive polycrystalline silicon film 30a, first metal film 27, high dielectric constant insulating film 26, and silicon oxide film 25 are patterned by an etching process using hard mask 31. At the same time, in memory cell formation region A, third meal film 32, second metal film 33, and n-conductive polycrystalline silicon film 30b are patterned. As a result, the first gate insulating film and the first gate electrode are formed on p-well 3 and the second gate insulating film and the second gate electrode are formed on n-well 2 in peripheral circuit formation region B, and bit line 34 is formed in memory cell formation region A.

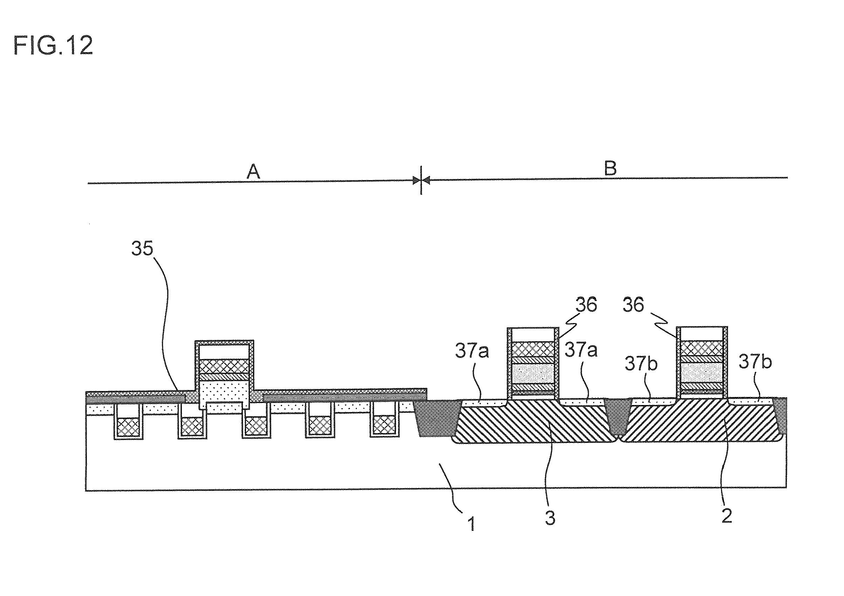

As shown in FIG. 12, Silicon nitride film 35 is formed as an offset spacer insulating film over semiconductor substrate 1, for example, by a CVD process. A sixth mask (not shown) is formed over memory cell formation region A, and silicon nitride film 35 is then etched back. Offset spacers 36 made of the silicon nitride film are thus formed on the sidewalls of the first and second gate insulating films and the first and second gate electrodes. After the sixth mask is removed, LDD region 37a is formed in p-well 3 and LDD region 37b is formed in n-well 2 by a known ion implantation process.

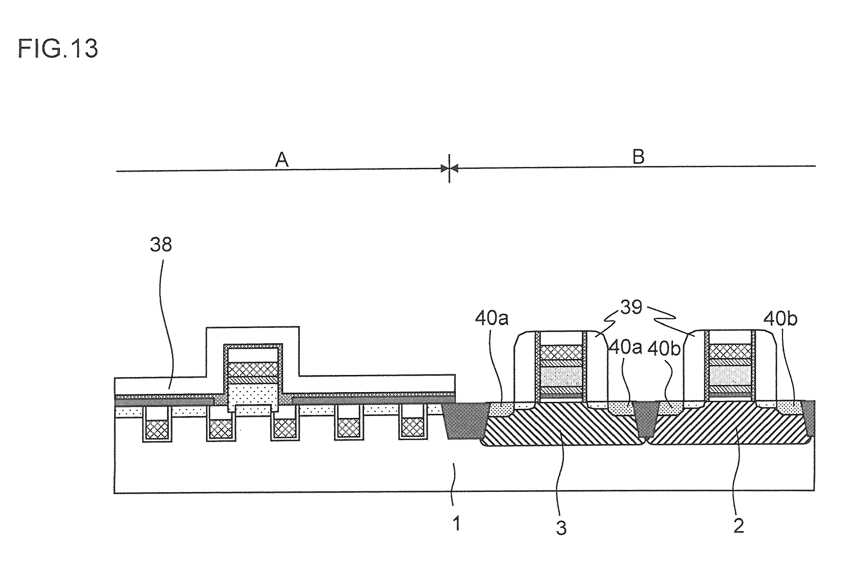

As shown in FIG. 13, silicon oxide film 38 is formed over semiconductor substrate 1, and a seventh mask (not shown) is then formed over memory cell formation region A. Offset spacers 39 made of the silicon nitride film are then formed on the sidewalls of the first and second gate insulating films and the first and second gate electrodes by etching back silicon oxide film 38. After the seventh mask is removed, source and drain regions 40a are formed in p-well 3 and source and drain regions 40b are formed in n-well 2 by a known ion implantation process.

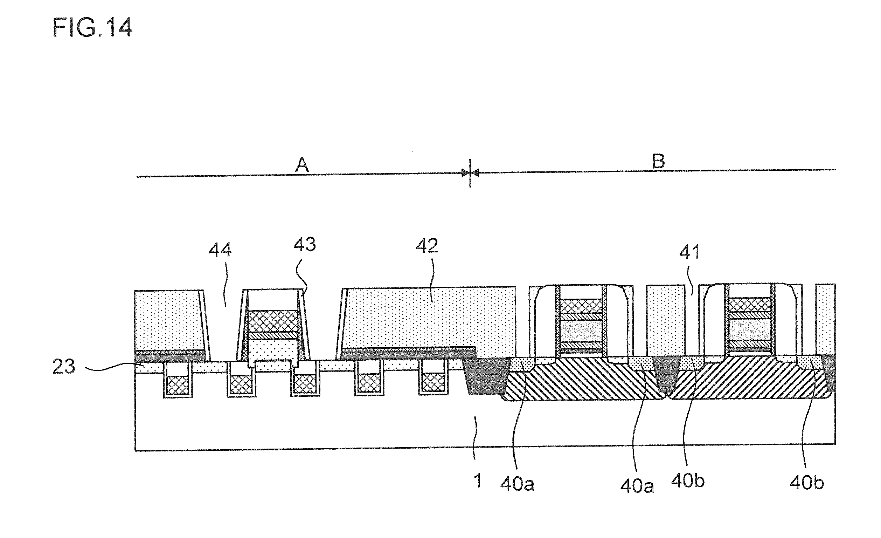

As shown in FIG. 14, first interlayer insulating film 42 is formed by forming a silicon oxide film over semiconductor substrate 1 and then performing CMP on the silicon oxide film by using the cap insulating films as a stopper. Contact holes 41 are then formed in first interlayer insulating film 42 by using a lithography technique so that source and drain regions 40a, 40b in peripheral circuit formation region B are exposed. Capacitance contact holes 44 are then formed in first interlayer insulating film 42 by using a lithography technique so that source and drain regions 23 in memory cell formation region A are exposed. Capacitance contact sidewall 43 is then formed on the inner wall side surface of each capacitance contact hole 44 by forming a silicon nitride film over memory cell formation region A and then etching back the silicon nitride film.

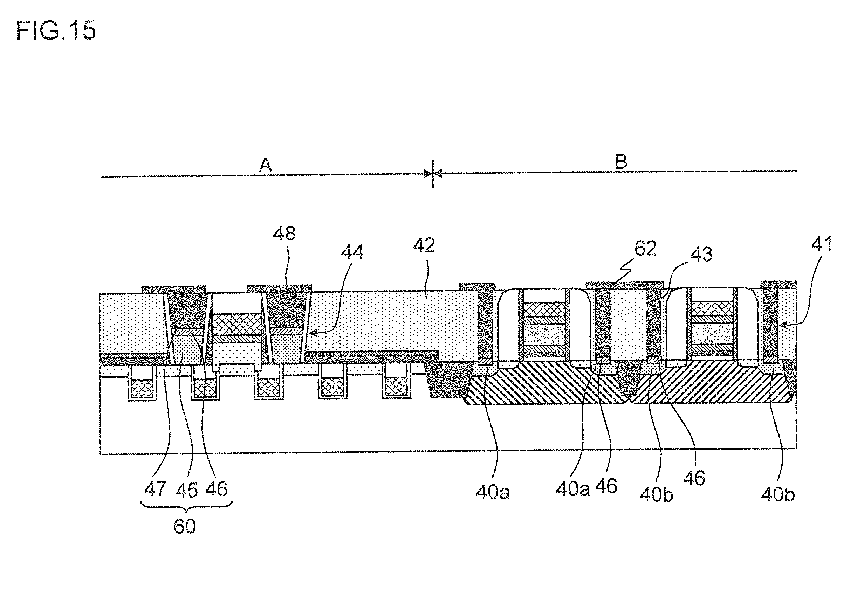

As shown in FIG. 15, a mask (not shown) is provided over peripheral circuit formation region B, and polycrystalline silicon film (DOPOS) 45 into which an impurity is doped, is formed in a lower portion of each capacitance contact hole 44. After the mask is removed, a cobalt film is formed on polycrystalline silicon film 45 and source and drain regions 40a, 40b, for example, by a sputtering process. The cobalt film is silicided to form cobalt silicide film 46 by heat treatment. A tungsten film is then formed in order to fill up capacitance contact holes 44 and contact holes 41, and the tungsten film on first interlayer insulating film 42 is removed by a planarization process. Thus, there are formed capacitance contact plugs 60, each of which is made of polycrystalline silicon film 45, cobalt silicide film 46, and tungsten film 47 in memory cell formation region A. Further, there are formed contact plugs 43, each of which is made of the tungsten film in peripheral circuit formation region B. Another tungsten film is formed on first interlayer insulating film 42 and then patterned. Thus, there are formed capacitance contact pads 48 connected to capacitance contact plugs 60 in memory cell formation region A and wirings 62 connected to contact plugs 43 in peripheral circuit formation region B.

As shown in FIG. 16, A silicon nitride film is formed on first interlayer insulating film 42. Second interlayer insulating film 49 is then formed by planarizing the silicon nitride film by a CMP process. Third interlayer insulating film 50 made of a silicon oxide film is formed on second interlayer insulating film 49. Capacitor holes are then formed in second and third interlayer insulating films 49, 50. Lower electrode 53 is formed on the inner wall of each of the capacitor holes. Third interlayer insulating film 50 in memory cell formation region A is then removed by using a lithography technique. Capacitance insulating film 58 is formed on the surface of each lower electrode 53. Upper electrodes 55 are then formed in order to fill up the capacitor holes and the spaces between the capacitance holes. Thus, there are capacitors Cap, each of which includes lower electrode 53, capacitance insulating film 58, and upper electrode 55. Each capacitor Cap is electrically connected to one of corresponding source and drain regions 23 via corresponding capacitance contact pad 48 and capacitance contact plug 60. The semiconductor device according to the second exemplary embodiment including a DRAM (dynamic random access memory) including capacitors, transistors, and bit lines is thus completed.

In the exemplary embodiment described above, each bit line 34 is formed of n-conductive polycrystalline silicon film 30b, barrier metal film 33, and third metal film 32. The structure of each of the bit lines is, however, not limited to the one described above. Each of the bit lines 34 may alternatively be formed of the barrier metal film and the third metal film without the polycrystalline silicon film. In this case, the step for the bit lines of implanting an n-conductive impurity into the polycrystalline silicon film (the step of FIG. 16) can be omitted.

It is apparent that the present invention is not limited to the above embodiments, but may be modified and changed without departing from the scope and spirit of the invention.

## Claims

1. A semiconductor device comprising an MIS field effect transistor,
the MIS field effect transistor comprising:
a channel region made of p-conductive silicon;
a gate insulating film including a first insulating film that is higher in dielectric constant than silicon dioxide; and
a gate electrode formed on the gate insulating film, the gate electrode including a first metal film and a p-conductive silicon film, the first metal film being greater in work function than intrinsic semiconductor silicon, the first metal film and the p-conductive silicon film being in contact with each other.

2. The semiconductor device according to claim 1,
wherein the first insulating film is higher in dielectric constant than silicon nitride.

3. The semiconductor device according to claim 1 or 2,
wherein the first insulating film and the first metal film are in contact with each other.

4. The semiconductor device according to any one of claims 1 to 3,
wherein the gate electrode further includes a second metal film in contact with the p-conductive silicon film, the second metal film being greater in work function than intrinsic semiconductor silicon, and
the p-conductive silicon film is formed between the first and second metal films.

5. The semiconductor device according to claim 4,
wherein the second metal film contains titanium nitride, tantalum nitride, hafnium nitride, titanium carbide or tungsten nitride

6. The semiconductor device according to any one of claims 1 to 5,
wherein the first metal film contains titanium nitride, tantalum nitride, hafnium nitride, or titanium carbide.

7. The semiconductor device according to any one of claims 1 to 6,
wherein the first insulating film contains at least one insulating material selected from the group consisting of HfSiON, ZrO₂, Ta₂O₅, Nb₂O₅, Al₂O₃, HfO₂, Sc₂O₃, Y₂O₃, La₂O₃, CeO₂, Pr₂O₃, Nd₂O₃, Sm₂O₃, Eu₂O₃, Gd₂O₃, Tb₂O₃, Dy₂O₃, Ho₂O₃, Er₂O₃, Tm₂O₃, Yb₂O₃, Lu₂O₃, HfSiO, ZrSiO and ZrSiON.

8. The semiconductor device according to any one of claims 1 to 7,
wherein concentration of a p-conductive impurity in the p-conductive silicon film ranges from 1×10²⁰ to 1×10²¹/cm³.

9. The semiconductor device according to any one of claims 1 to 8,
wherein the p-conductive silicon film contains at least one element selected from the group consisting of boron, indium, and gallium.

10. A method for manufacturing a semiconductor device, comprising:
implanting a donor impurity into part of a semiconductor substrate to form a first semiconductor region having n-conductive type;
implanting an acceptor impurity into other part of the semiconductor substrate to form a second semiconductor region having p-conductive type;
forming a first insulating film on the semiconductor substrate to cover the first and second semiconductor regions, the first insulating film being higher in dielectric constant than silicon dioxide;
forming a conductive film on the first insulating film, the conductive film comprising a first metal film and a p-conductive silicon film, the first metal film and the p-conductive silicon film being in contact with each other, the first metal film being greater in work function than intrinsic semiconductor silicon; and,
partially removing the conductive film and the first insulating film to form gate structures on each surfaces of the first and second semiconductor regions.

11. The method according to claim 10,
wherein the first insulating film is higher in dielectric constant than silicon nitride.

12. The method according to claim 10 or 11,
wherein the first metal film is formed in contact with the first insulating film.

13. The method according to any one of claims 10 to 12, further comprising:
forming a second metal film so as to be in contact with the p-conductive silicon film, the second metal film being greater in work function than intrinsic semiconductor silicon.

14. The method according to any one of claims 10 to 13, further comprising:
forming, before forming the first insulating film, a second insulating film on the semiconductor substrate to cover the first and second semiconductor regions, the second insulating film comprising silicon dioxide.

15. The method according to any one of claims 10 to 14, further comprising:
implanting an acceptor impurity into the first semiconductor region to form a pair of p-type source and drain regions by using the gate structure thereon as an implantation mask; and
implanting a donor impurity into the second semiconductor region to form a pair of n-type source and drain regions by using the gate structure thereon as an implantation mask.
